# EUROPÄISCHE PATENTSCHRIFT

(11) **EP 2 985 796 B1**
(45) Veröffentlichungstag und Bekanntmachung des Hinweises auf die Patenterteilung: **01.11.2017**
(21) Anmeldenummer: 15170452.5
(22) Anmeldetag: 03.06.2015
(51) Int. Cl.: H01L 43/06, G01R 33/07

(54) **KOMPONENTE MIT REDUZIERTEN SPANNUNGSKRÄFTEN IM SUBSTRAT**
COMPONENT WITH REDUCED TENSION FORCES IN THE SUBSTRATE
COMPOSANTS DOTÉS DE FORCES DE CONTRAINTE RÉDUITES DANS UN SUBSTRAT

(30) Priorität: 14.08.2014 DE 102014111636
(43) Veröffentlichungstag der Anmeldung: 17.02.2016
(60) Teilanmeldung: 16167008.8
(73) Patentinhaber: TDK-Micronas GmbH, 79108 Freiburg (DE)
(72) Erfinder: Baumann, Marc, 79108 Freiburg (DE); Rubehn, Thilo, 79108 Freiburg (DE); Joos, Christian, 79108 Freiburg (DE); Stephan, Jochen, 79108 Freiburg (DE)
(74) Vertreter: Harrison, Robert John

(56) Entgegenhaltungen:
- DE-A1-102005 014 157
- DE-A1-102011 002 580
- US-A1- 2007 290 682

## Beschreibung

Die Erfindung betrifft einen Magnetfeld-Sensor, wobei der Magnetfeld-Sensor zum Teil von einem Graben in einem Halbleiter-Substrat umrandet ist.

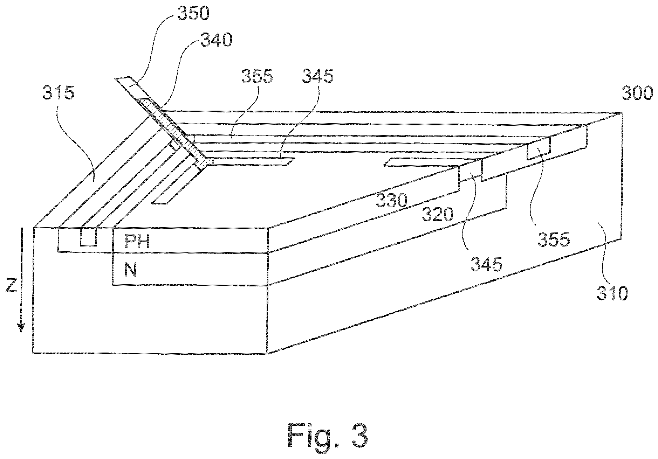

Fig. 3 zeigt den Querschnitt einer möglichen Ausführungsform eines lateralen Hall-Sensors 300 in CMOS Technologie mit einer Sensitivität auf die vertikale Magnetfeldkomponente (entlang der z-Achse) und einem Silizium-Substrat 310. Die funktionalen Schichten des Hall-Sensors 300 befinden sich unterhalb der Oberfläche 315 des Silizium-Substrats 310 in entsprechenden mittels Dotierung abgegrenzten Gebieten 320, 330 des Halbleiter-Substrates 310. Die erste Schicht 320 ist in dieser Ausführungsform eine n- Schicht und die darauf liegende zweite Schicht 330 ist eine p-Schicht. Die Kontaktierung des Hall-Sensors 300 sowie anderer Komponenten in dem Silizium-Substrat 310 erfolgt durch den weiteren Schichtaufbau auf dem Substrat mittels Metallleiterbahnen 340 und 350. Aus Fig. 3 ist zu entnehmen, dass die Metallleiterbahnen 340 und 350 die Dotiergebiete über entsprechende Kontaktdiffusionen 345 und 355 kontaktieren.

Der Hall-Sensor 300 kann auch als ein Array mit einer Vielzahl von miteinander verschalteten Hall-Elementen gebildete werden. Je nach Ausführungsform kann das Array laterale sowie vertikale Hall-Elemente beinhalten, welche auf die vertikale bzw. horizontale Magnetfeldkomponente empfindlich sind.

Andere Magnetfeldsensoren wie TMR, AMR, etc. sind üblicherweise auf der Oberfläche 315 des Halbleiter-Substrats 310 angebracht. Die Lehre dieses Dokuments umfasst auch Magnetfeld-Sensoren und andere elektronische Komponenten, die eine integrierte Komponente auf der Oberfläche eines Halbleitersubstrates aufweisen, welche u.a. in das Halbleiter-Substrat 310 hineinreicht / hineinreichen kann (wie zum Beispiel bei der CMOS-Technologie).

Es ist bekannt, dass der piezoresistive sowie der Piezo-Hall-Effekt die Performance von Hall-Sensoren negativ beeinflusst. Die unter anderem beim Verpackungsprozess induzierten komplexen mechanischen Spannungszustände in dem Halbleiter-Substrat 310, auf oder in dem ein Hall-Sensor 300 angebracht ist, können nur unzureichend erfasst und deren Einfluss auf die Hall-Elemente nur bedingt und mit erheblichem Aufwand kompensiert werden. Des Weiteren zeigt die induzierte mechanische Spannung im Hall-Element eine starke Abhängigkeit von Umgebungseinflüssen wie zum Beispiel von der Temperatur und der relativen Luftfeuchtigkeit. Langsame Veränderungen des mechanische Spannungszustandes über die Lebensdauer des Hall-Sensors 300 und der anderen Komponenten, hervorgerufen durch plastische Deformationen (im Verbundkörper) sind ebenfalls nur hinzureichend detektierbar und lassen sich für eine Kompensation dieser Einflüsse auf die Eigenschaften des Hall-Sensors 300 nur eingeschränkt verwenden.

Aus dem Stand der Technik sind verschiedene Verfahren bekannt, welche die Einflüsse mechanischer Spannungszustände in dem Halbleiter-Substrat auf das Sensor-Element kompensieren. Zum Beispiel wird zur Offsetreduktion die sogenannte "current spinning" Methode, auch als "current switching" Methode bekannt, verwendet.

Das Spinning-Current-Verfahren ist im Zusammenhang mit lateralen Hall-Sensoren 300 zur Unterdrückung des Offsets des Sensorsignals aus dem Buch "Rotary Switch and Current Monitor by Hall-Based Microsystems" der Autoren Ralph Steiner Vanha, Verlag Physical Electronics Laboratory, Swiss Federal Institute of Technology (ETH) Zürich, 1999, Seiten 39-53, bekannt. Das Spinning-Current-Verfahren besteht darin, die Mess- und Stromrichtung am Hall-Sensor 300 ständig mit einer bestimmten Taktfrequenz um beispielsweise 90° zyklisch weiter zu drehen und über alle Messsignale einer vollen Drehung um 360° zu summieren und dadurch den Einfluss von Offset-Spannungen zu reduzieren.

Die Langzeit-Drift der magnetischen Empfindlichkeit von Hall-Sensoren ist in der Veröffentlichung "Compensation of the Piezo-Hall-Effect in Integrated Hall-Sensors on (100)-Si", Udo Ausserlechner et al., IEEE Sensors Journal Vol. 7, Nr. 11, November 2007, 1475-1482 angesprochen. Die Autoren haben festgestellt, dass diese Langzeitdrift durch Veränderungen in der mechanischen Spannungsbildung im Halbleiter-Substrat durch das Packaging verursacht ist. In dieser Veröffentlichung wird ein System offenbart, welches die Spannungskomponenten im Halbleiter-Substrat misst und somit die Empfindlichkeitsdrift schätzt. Eine Korrektur kann bei den ermittelten Messwerten vorgenommen werden. Das US Patent Nr. US7980138 offenbart auch diese Vorrichtung. Das Patent schützt ein Verfahren zur Stressmessung auf einem IC mittels mindestens zweier verschalteter piezoresistiver Widerstände.

Aus dem US Patent Nr. US 5,600,074 (Marek et al.) ist ein Silizium-Halbleiter-Substrat zur Verwendung in einem Kraft-Sensor bekannt. Dieses Patent zeigt parallel angeordnete Gräben zum Schutz von elektrischen Schaltungen vor mechanischem Stress bei vertikaler Belastung eines Halbleiter-Substrats.

Zwar kann die Empfindlichkeitsdrift des Hall-Sensors 300, hervorgerufen durch Änderungen der mechanische Spannungszustände nach dem Abgleich des Hall-Sensors 300, mit dem System aus der Ausserlechner-Veröffentlichung kompensiert werden, allerdings unterliegen die mechanischen Spannungssensoren selbst einer unerwünschten Querabhängigkeit wie zum Beispiel von der Temperatur, welche wiederum auch kompensiert werden muss. Es ist auch bekannt, dass die mechanische Spannungsmessung in einem Halbleiter-Substrat sehr aufwändig ist und Chipfläche benötigt ("Real-Estate"), welche nicht mehr für andere Komponenten verfügbar ist, bzw. welche die Stromaufnahme und die Herstellungskosten des ICs erhöht. Eine Ungenauigkeit in den Messwerten ergibt sich auch dadurch, dass die mechanischen Spannungen im Halbleiter-Substrat an anderen Stellen gemessen werden als die mechanischen Spannungen, welche unmittelbar im Bereich bei den Hall-Sensoren wirken. Die zusätzlichen Spannungsmessungen erfordern auch einen erhöhten Verarbeitungsaufwand der Messsignale, was wiederum mit einem höheren schaltungstechnischen Aufwand verbunden ist.

Um diese Nachteile zu adressieren, wird in der japanischen Patentanmeldung Nr. JP H09-97895 und japanischen Patentanmeldung Nr. 2004-235328 ein Magnetfeld-Sensor auf oder in einem Halbleiter-Substrat beschrieben, wobei der Magnetfeld-Sensor zumindest zum Teil von einem Graben in einem Halbleiter-Substrat umrandet ist. Somit werden die mechanischen Spannungskomponenten in dem Halbleiter-Substrat im Bereich der Oberfläche weitgehend vermieden.

Ein wesentlicher Nachteil des Herstellungsprozesses dieser japanischen Patentanmeldungen ist, dass sich dieser Graben beim folgenden Verpackungsprozess des Magnetfeldsensors, d.h. beim Umspritzen (Verkapseln) der Bauteile mit der Vergussmasse partiell bzw. vollständig füllen kann. Dadurch entsteht eine starre mechanische Verbindung zwischen den Grabenwänden, wodurch mechanische Spannungen von einer Seite zur anderen übertragen werden können. Deshalb wird die gewünschte Spannungsreduktion im Bereich des Sensorelements stark vermindert bzw. vollständig aufgehoben. (Je nach verwendeter Vergussmasse kann es sogar zu einer Verstärkung des mechanischen Spannungszustands im Sensorbereich kommen.)

Ist der Graben nur teilweise mit dem Verkapselungsmaterial gefüllt entstehen Kavitäten, welche sich mit Wasser füllen können wenn das Bauteil Feuchtigkeit ausgesetzt wird. Ein plötzlicher Temperaturanstieg, wie er z.B. beim Auflöten eines verpackten Bauteils entsteht, führt dann zum Aufplatzen der Ummantelung (Popcorn-Effekt) und somit zur Zerstörung des Bauteils.

Um diese und weitere Nachteile des Standes der Technik zu adressieren, wird der Graben mit einem geeigneten Material, im Folgenden Puffermaterial genannt, gefüllt. Die Vergussmasse kann nun nicht mehr beim Umspritzen in den Graben eindringen. Das Puffermaterial nimmt die auftretenden Spannungskräfte, welche in dem Verbundkörper bei der Fertigung entstehen auf und leitet diese nicht an den Sensor weiter.

Des Weiteren kann eine zusätzliche Schicht eines Puffermaterials auf dem Halbleiter-Substrat aufgebracht werden, um mechanische Spannungen, welche zwischen der Si- bzw. Sensoroberfläche (Insel) und der Vergussmasse wirken, zu absorbieren.

In einem weiteren Ausführungsbeispiel wird der Graben sowie das Sensorelemente mit einer Kappe bedeckt, um das Eindringen von Vergussmasse in den Graben beim Verkapselungsprozess zu verhindern. Die Kappe wird auf dem Si-Substrat geeignet verklebt und kann typischerweise im Bereich des Graben und des Sensorelements eine Aussparung / Kavität aufweisen.

In einem Aspekt der Erfindung, können beide genannte Verfahren auch kombiniert werden, d.h. die Kappe kann auch über einem gefüllten Graben mit / ohne Pufferschicht verklebt werden.

Mit Hilfe dieser Struktur ist es nicht mehr erforderlich, zusätzliche Sensoren für die Messung der mechanischen Spannung und einen Signalverarbeitungs-Prozessor für die Auswertung der Kompensationseffekte bereitzustellen. Die Siliziumfläche (Real Estate) für diese zusätzlichen Bauteile wird nicht in Anspruch genommen und der Stromverbrauch wird verringert.

Der Graben wird fertigungstechnisch in einer Ausführungsform bevorzugt mit Hilfe eines Laserabtrags erzeugt. Alternativ, kann der Abtrag auch mittels eines geeigneten physikalischen Trockenätzprozesses (Reaktives Ionen Ätzen (RIE), Tiefes Reaktives Ionen Ätzen (Bosch Prozess, DRIE), Ionen Strahl schneiden), oder durch nasschemisches Ätzen mittels KOH oder beispielsweise EDP erfolgen.

In einem Aspekt ist der Magnetfeld-Sensor weitgehend von dem Graben umrandet; damit wird eine Insel im Halbleiter-Substrat mit dem Magnetfeld-Sensor gebildet. Eine Verbindung zwischen einem Signalverarbeitungs-Prozessor und dem Magnetfeld-Sensor wird auf einem Verbindungssteg zwischen der Insel und dem sonstigen Teil des Halbleiter-Substrats durch darauf verlaufende Leiterbahnen oder durch hochleitende Diffusionen im Silizium-Substrat bereitgestellt.

Ein weiterer Stand der Technik findet sich in Patentschrift DE102011002580.

Um eine ausreichende Isolation der mechanischen Spannung zu erreichen, weist der Graben eine Tiefe auf, welche z. B. zumindest ein zwanzigstel der Diagonalen der Insel auf der Oberfläche oder 5 µm ist. In einer anderen Ausführungsform kann der Graben das Silizium-Substrat vollständig durchdringen. Die Breite des Grabens beträgt weniger als 100 µm, damit nicht zu viel Silizium-Fläche in Anspruch genommen wird. Der Graben wird anschließend mit einem Füllmaterial (Puffermaterial) befüllt.

Der Magnetfeld-Sensor kann ein Hall-Sensor oder ein anderer Sensor sein, welcher sensitiv auf mechanische Spannungen ist. Darüber hinaus kann die Insel auch zusammen mit dem Hall-Sensor mehrere weitere Komponenten enthalten, die eine Querempfindlichkeit auf mechanische Spannungen aufweisen und zur Signalverarbeitung des/der Magnetfeld-Sensoren benötigt werden, wie zum Beispiel analog digital Wandler oder Spannungs- und Stromquellen zur Sensorversorgung.

Die Erfindung wird nun an Hand der folgenden Figuren näher erläutert. Es zeigen:
Fig. 1a eine Seitenansicht der Komponente.
Fig. 1b eine Draufsicht der Komponente.
Fig. 1c die Seitenansicht mit befülltem Graben.
Fig. 1d die Seitenansicht einer Komponente mit Deckel.
Fig. 2a 2p mehrere Baukomponenten mit unterschiedlich angeordneten Laufstegen.
Fig. 3 einen lateralen Hall-Sensor nach dem Stand der Technik.

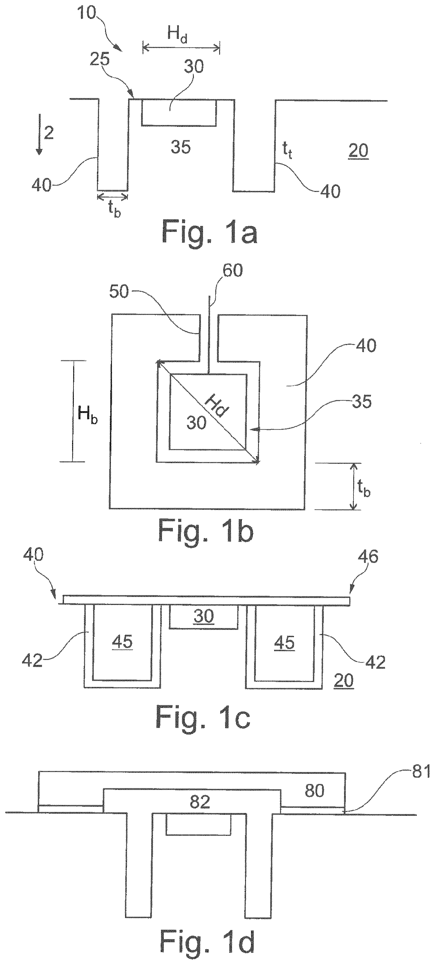

Fig. 1a zeigt eine Seitenansicht einer Komponente 10 gemäß einem Aspekt dieser Erfindung. Ein Magnetfeld-Sensor 30 ist in einem Halbleiter-Substrat 20 eingebracht (integriert) oder auf einer Oberfläche 25 des Halbleiter-Substrats 20 angeordnet.

Der Magnetfeld-Sensor 30 ist zumindest zum Teil von einem Graben 40 umrandet. Wie der Figur 1b zu entnehmen ist, umrandet der Graben 40 in diesem Aspekt der Offenbarung das elektronische Bauteil 30 weitgehend, aber nicht vollständig, und bildet eine Art "Insel" 35 im Halbleiter-Substrat 20.

Ein Verbindungssteg 50 führt zwischen dem Inselteil der Oberfläche 25 und dem sonstigen Teil des Halbleiter-Substrats 20. Über den Verbindungssteg 50 verlaufen Metallleiterbahnen 60, welche den Magnetfeld-Sensor 30 auf der Insel mit weiteren Metallleiterbahnen auf dem übrigen Teil der Oberfläche 25 verbinden. Ein Hall-Sensor benötigt z.B. mindestens vier Leitungen 60 für die vier Anschlüsse oder elektronische Verbindungen. Die elektrischen Verbindungen können anstelle von Metallleiterbahnen auch mittels geeigneter Diffusionen auf dem Verbindungssteg realisiert werden.

Der Graben 40 weist eine Tiefe tₜ auf, welche zumindest 5 µm oder ein Zwanzigstel der Diagonalen H_{d} der Insel 35 auf der Oberfläche 25 betragen sollte. Der Graben 40 kann das Halbleiter-Substrat 20 auch vollständig durchdringen. Der Graben 40 um die Insel 35 führt dazu, dass der Magnetfeld-Sensor 30 weitgehend von Spannungskräften in dem Halbleiter-Substrat 20 isoliert ist. Der Magnetfeld-Sensor 30 auf der Insel 35 wird somit durch die Spannungskräfte in dem Halbleiter-Substrat 20 nicht beeinflusst.

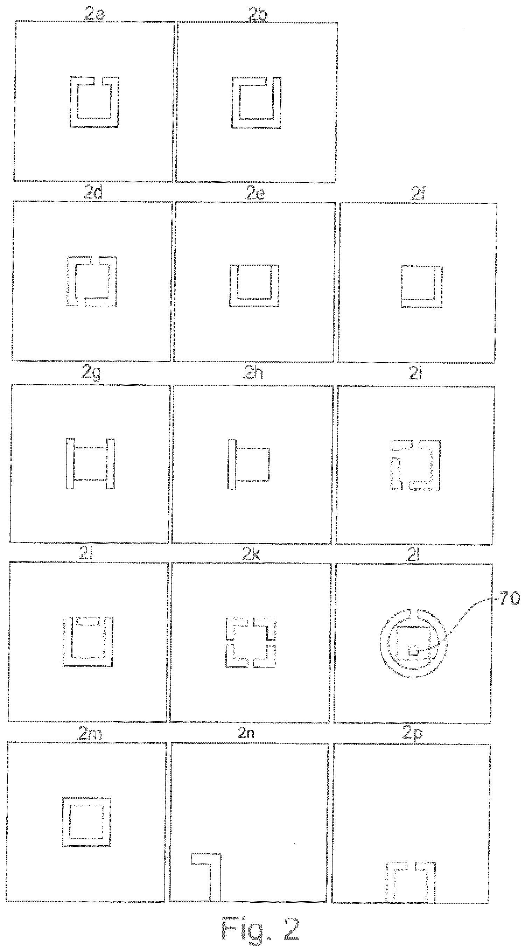

Wie der Fig. 2 zu entnehmen ist, muss der Verbindungssteg 60 nicht mittig auf einer Seite der Insel im Graben 40 verlaufen. Der Verbindungssteg 50 kann auch seitlich angeordnet werden, wie aus Figur 2b zu entnehmen ist. Es können ebenfalls zwei Verbindungsstege 50 vorhanden sein (siehe Fig. 2d). In einigen weiteren Ausführungsformen muss der Graben 40 die Insel 35 nicht vollständig umranden, um die gewünschte Isolation der Spannungskräfte zu erzielen oder die Ausbreitung derselben zu unterbinden. Fig. 2e - 2h zeigen z.B. Aspekte der Struktur, bei denen der Graben 40 die Insel 35 nicht vollständig umrandet. Zwar ist die mechanische Isolierung bei den Aspekten gemäß Fig. 2e - h nicht so stark, wie in anderen Aspekten, die Herstellung solcher Gräben 40 kann kosteneffizienter erzielt werden, und die Insel 35 ist mechanisch robuster mit dem übrigen Halbleiter-Substrat 20 verbunden.

Fig. 2i - 2m zeigen weitere Ausführungsformen des Grabens 40, wobei in Fig. 2m der Graben 40 ohne einen Verbindungssteg 50 ausgebildet ist. Die Kontaktierung des elektronischen Bauteils kann in diesem Fall z.B. durch Bondverbindungen hergestellt werden. Weiterhin ist es möglich, dass der Magnetfeld-Sensor 30 nicht nur ein einzelnes elektronisches Bauteil auf seiner Oberfläche 25 enthalten kann, sondern auch zusätzliche Komponenten 70 aufweist. Fig. 2l zeigt eine andere Form des Grabens 40 mit einer weiteren Komponente 70. Fig. 2p zeigt eine mögliche Ausführungsform mit einer Insel 35 am Rande des Halbleiter-Substrats 20 und Fig. 2n zeigt eine mögliche Ausführungsform mit einer Insel in einer Ecke des Halbleiter-Substrats 20.

Der Graben 40 wird mittels eines herkömmlichen Ätzverfahrens zum Beispiel durch Laserabtrag oder sonstiges physikalisches bzw. nasschemisches Ätzen erhalten. Als sonstige Ätzverfahren kommen in Betracht Trockenätzprozesse (Reaktives Ionen Ätzen - RIE, Tiefes Reaktives Ionen Ätzen - Bosch Prozess, DRIE und Ionen Strahl Schneiden), oder nasschemisches Ätzen mittels KOH oder EDP. Der Magnetfeld-Sensor 30 und die anderen Komponenten werden durch übliche Herstellungsschritte gefertigt.

Der Graben 40 ist in Fig. 1c optional mit einer oder mehrerer Komponenten zum Schutz gegen äußere Umwelteinflüsse teilweise an seiner inneren Oberfläche ausgekleidet (passiviert). Als Auskleidungsschicht 42 wird bevorzugt ein Nitrid, z.B. Si₃N₄ oder ein Polymid verwendet. Der Graben 40 wird mit oder ohne Auskleidung vollständig gefüllt, wobei die Füllung des Grabens auch mit mehrerer Schichten unterschiedlicher Puffermaterialien erfolgen kann. Das Puffermaterial / die Puffermaterialien 45 hat/haben typischerweise ein kleineres Elastizitäts- bzw. Bulkmodul als das Substrat. Als Puffermaterial wird bevorzugt ein Polymer, z.B. ein Elastomer wie eine Silikonverbindung oder ein anderes geeignetes Material verwendet welches die auftretenden mechanischen Spannungen im gefüllten Graben absorbieren kann. Das Puffermaterial kann aber auch ein Epoxidharz sein. Das Füllen des Grabens 40 ermöglicht eine weitere Verkapselung der Komponente, wobei keine, bzw. nur geringe mechanische Spannungen über das Füllmaterial 45 vom Substrat an die Insel übertragen werden.

Eine weitere Pufferschicht 46 kann auf der Oberfläche 25 des Halbleitersubstrats und des befüllten Grabens 40 aufgezogen werden. Diese Pufferschicht nimmt die mechanischen Spannungen auf, welche von der Vergussmasse an der Oberfläche der Insel angreifen. Die Pufferschicht bedeckt typischerweise zumindest die Insel wie auch den Graben und bedeckt daher die gesamte Si-Oberfläche nur partiell. In einem Aspekt besteht die Pufferschicht aus dem gleichen Material mit welchem die Gräben gefüllt sind. Alternativ kann die Pufferschicht 46 aus einer Kunststofffolie durch Aufkleben auf der Oberfläche 25 aufgebracht werden. (Fig. 1c zeigt einen Graben 40 mit Verkapselungsschicht 42 und Pufferfüllmaterial 45 sowie Pufferschicht 46.)

Fig. 1d zeigt ein Bauteil mit Kappe 80 welche mittels einer Kleberschicht 81 über der Insel befestigt ist. Die Kappe 80 schließt in ihrer Kavität ein Luftvolumen 82 ein. Die Kappe schützt den Graben vor dem Eindringen von Material beim Verkapselungsprozess sowie vor dem Eindringen von Feuchtigkeit und der Bildung von Wasserreservoirs in dem Graben. Alternativ kann die Kappe 80 auch auf ein Bauteil mit gefülltem Graben mit/ohne Pufferschicht über der Inseloberfläche aufgebracht werden. Die Kappe 80 ist typischerweise aus einem nichtmagnetischen Material gefertigt. Wird ein nichtmagnetisches und elektrisch leitfähiges Material wie z.B. Kupfer verwendet, wird das Sensorelement zusätzlich vor elektromagnetischer Strahlung abgeschirmt.

Darüber hinaus kann die Komponente 10 neben dem Magnetfeld-sensor 30 auch mehrere Magnetfeldsensoren, sowie schaltungstechnische Komponenten, die eine Querempfindlichkeit auf mechanische Spannungen aufweisen, beinhalten und zur Signalverarbeitung des/der Magnetfeld-Sensoren benötigt werden, wie zum Beispiel analog digital Wandler oder Spannungs- und Stromquellen zur Sensorversorgung.

## Patentansprüche

1. Komponente (10) umfassend
ein Halbleiter-Substrat (20) mit einer Oberfläche (25);
einem Magnetfeld-Sensor (30); und
einem mit einem Füllmaterial (45) befüllten Graben (40) im Halbleiter-Substrat (20), welcher den Magnetfeld-Sensor (30) zumindest zum Teil umrandet, **dadurch gekennzeichnet, dass** das Füllmaterial (45) ein Puffermaterial ist, welches mechanische Spannungen absorbiert.

2. Komponente (10) nach Anspruch 1, wobei die Oberfläche (25) eine Pufferschicht (26) aufweist.

3. Komponente (10) nach Anspruch 1 oder 2, wobei der Graben (40) und der Magnetfeld-Sensor (30) mit einer Kappe (80) bedeckt sind/werden.

4. Komponente (10) nach einem der Ansprüche 1 bis 3, wobei der Graben (40) den Magnetfeld-Sensor (30) weitgehend umrandet, um eine Insel (35) zu bilden, und weiterhin einen Verbindungssteg (50) aufweist.

5. Komponente (10) nach einem der vorhergehenden Ansprüche, mit Leiterbahnen (60), Diffusionen oder Bondverbindungen, welche elektronische Verbindungen des Magnetfeld-Sensors (30) kontaktieren, und über den Verbindungssteg (50) geführt sind.

6. Komponente (10) nach einem der vorhergehenden Ansprüche, wobei der Magnetfeld-Sensor (30) in dem Halbleiter-Substrat (20) integriert ist.

7. Komponente (10) nach einem der vorhergehenden Ansprüche, wobei der Magnetfeld-Sensor (30) ein Hall-Sensor ist.

8. Komponente (10) nach einem der vorhergehenden Ansprüche, wobei der Graben (40) eine Tiefe (tₜ) aufweist, welche zumindest 5 µm oder ein zwanzigstel der Diagonalen (H_{d}) des Magnetfeld-Sensors (30) ist.

9. Komponente (10) nach einem der vorhergehenden Ansprüche, wobei der Graben (40) das Halbleiter-Substrat (20) vollständig durchdringt.

10. Komponente (10) nach einem der vorhergehenden Ansprüche, wobei die Breite (t_{b}) des Grabens (40) weniger als 100 µm beträgt.

11. Komponente (10) nach einem der vorhergehenden Ansprüche, wobei das Füllmaterial ein Polymer oder Polyimid ist.

12. Komponente (10) nach einem der vorhergehenden Ansprüche, wobei die Oberfläche (42) des Grabens (40) eine Verkapselungsschicht (42) aufweist.

13. Komponente (10) nach Anspruch 12, wobei die Verkapselungsschicht ein Nitrid ist.

14. Komponente (10) nach einem der vorhergehenden Ansprüche, wobei der Graben durch Laserabtragen hergestellt ist.

15. Bauelement (100) mit einer Komponente (10) nach einem der vorhergehenden Ansprüche, umfassend eine weitere Komponente (70), die vom Graben (40) zumindest zum Teil umrandet ist.

16. Bauelement (100) nach Anspruch 15, wobei die weitere Komponente (70) eine schaltungstechnische Komponente zur Steuerung des Magnetfeldsensors (30) oder zur Erfassung der Daten aus dem Magnetfeld-Sensors (30) ist.

## Claims

1. A component (10) comprising
a semiconductor substrate (20) with a surface (25);
a magnetic field sensor (30); and
a trench (40) filled with a filling material (45) in the semiconductor substrate (20), said trench surrounding the magnetic field sensor (30) at least partially, **characterized in that** the filling material is a buffer material absorbing mechanical stress.

2. The component (10) according to claim 1, wherein the surface (25) has a buffer layer (26).

3. The component (10) according to claim 1 or 2, wherein the trench (40) and the magnetic field sensor (30) is/ are covered with a cap (80).

4. The component (10) according to any of the claims 1 to 3, wherein the trench (40) surrounds the magnetic field sensor (30) largely, in order to form an island (35), and further has a connecting web (50).

5. The component (10) according to any of the preceding claims, with conductor paths (60), diffusions or bonding connections, which contact the electronic connections of the magnetic field sensor (30) and are guided over the connecting web (50).

6. The component (10) according to any of the preceding claims, wherein the magnetic field sensor (30) is integrated in the semiconductor substrate (20).

7. The component (10) according to any of the preceding claims, wherein the magnetic field sensor (30) is a Hall sensor.

8. The component (10) according to any of the preceding claims, wherein the trench (40) has a depth (tₜ) which is at least 5 µm or one twentieth of the diagonal (H_{d}) of the magnetic field sensor (30).

9. The component (10) according to any of the preceding claims, wherein the trench (40) penetrates the semiconductor substrate (20) fully.

10. The component (10) according to any of the preceding claims, wherein the width (t_{b}) of the trench (40) is less than 100 µm.

11. The component (10) according to any of the preceding claims, wherein the filling material is a polymer or polyimide.

12. The component (10) according to any of the preceding claims, wherein the surface (42) of the trench (40) has an encapsulation layer (42).

13. The component (10) according to claim 12, wherein the encapsulation layer is a nitride.

14. The component (10) according to any of the preceding claims, wherein the trench is produced by laser removal.

15. A device (100) with a component (10) according to any of the preceding claims, comprising a further component (70) that is surrounded at least partially by the trench (40).

16. The device (100) according to claim 15, wherein the further component (70) is a circuitry component for controlling the magnetic field sensor (30) or for capturing the data from the magnetic field sensor (30).

## Revendications

1. Composant (10) comprenant
un substrat semi-conducteur (20) avec une surface (25) ;
un capteur de champ magnétique (30) ; et
une tranchée (40) remplie d'un matériau de remplissage (45) dans le substrat semi-conducteur (20), la tranchée entourant au moins partiellement le capteur de champ magnétique (30),
**caractérisé en ce que**
le matériau de remplissage (45) est un matériau tampon, qui absorbe les tensions mécaniques.

2. Composant (10) selon la revendication 1, dans lequel la surface (25) comprend une couche tampon (26).

3. Composant (10) selon la revendication 1 ou 2, dans lequel la tranchée (40) et le capteur de champ magnétique (30) sont recouverts d'un capuchon (80).

4. Composant (10) selon l'une quelconque des revendications 1 à 3, dans lequel la tranchée (40) entoure en grande partie le capteur de champ magnétique (30), afin de former un ilot (35), et a en outre un pont de liaison (50).

5. Composant (10) selon l'une quelconque des revendications précédentes, avec des pistes conductrices (60), des diffusions ou des liaisons de connexion, qui sont en contact avec les connexions électroniques du capteur de champ magnétique (30) et sont guidés sur / par le pont de liaison (50).

6. Composant (10) selon l'une quelconque des revendications précédentes, dans lequel le capteur de champ magnétique (30) est intégré dans le substrat semi-conducteur (20).

7. Composant (10) selon l'une quelconque des revendications précédentes, dans lequel le capteur de champ magnétique (30) est un capteur Hall.

8. Composant (10) selon l'une quelconque des revendications précédentes, dans lequel la tranchée (40) a une profondeur (tₜ) qui est d'au moins 5 µm ou un vingtième de la diagonale (H_{d}) du capteur de champ magnétique (30).

9. Composant (10) selon l'une quelconque des revendications précédentes, dans lequel la tranchée (40) pénètre complètement dans le substrat semi-conducteur (20).

10. Composant (10) selon l'une quelconque des revendications précédentes, dans lequel la largeur (t_{b}) de la tranchée (40) est inférieure à 100 µm.

11. Composant (10) selon l'une quelconque des revendications précédentes, dans lequel le matériau de remplissage est un polymère ou un polyimide.

12. Composant (10) selon l'une quelconque des revendications précédentes, dans lequel la surface (42) de la tranchée (40) comprend une couche d'encapsulation (42).

13. Composant (10) selon la revendication 12, dans lequel la couche d'encapsulation est un nitrure.

14. Composant (10) selon l'une quelconque des revendications précédentes, dans lequel la tranchée est produite par ablation au laser.

15. Elément de construction (100) avec un composant (10) selon l'une quelconque des revendications précédentes, comprenant un autre composant (70) entouré au moins partiellement par la tranchée (40).

16. Elément de construction (100) selon la revendication 15, dans lequel l'autre composant (70) est un composant de circuit pour commander le capteur de champ magnétique (30) ou pour capturer les données à partir du capteur de champ magnétique (30).
